(19) Europäisches Patentamt
European Patent Office
Office européen des brevets

(11) **EP 2 202 619 A1**

(12) **EUROPEAN PATENT APPLICATION**

(43) Date of publication:
**30.06.2010 Bulletin 2010/26**

(51) Int Cl.:
*G06F 3/041* (2006.01)     *G06F 3/01* (2006.01)

(21) Application number: **08172725.7**

(22) Date of filing: **23.12.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Research In Motion Limited**
**Waterloo, Ontario N2L 3W8 (CA)**

(72) Inventors:
• **Weber, Arnett**
**Waterloo Ontario N2V 1S9 (CA)**

• **Faubert, Perry Allan**
**Kitchener Ontario N2A 4M1 (CA)**

(74) Representative: **Fennell, Gareth Charles**
**Kilburn & Strode LLP**
**20 Red Lion Street**
**London WC1R 4PJ (GB)**

Remarks:
Amended claims in accordance with Rule 137(2) EPC.

(54) **Portable electronic device including tactile touch-sensitive input device and method of controlling same**

(57)     A method of controlling an electronic device having a touch-sensitive input surface includes monitoring the touch-sensitive input surface of a touch event thereon, and modulating a force on the touch-sensitive input surface for causing a first movement of the touch-sensitive input surface relative to a base of the electronic device in response to detection of a touch event on the touch-sensitive input surface. The force is applied by at least one actuator in a single direction on the touch-sensitive input surface..

Figure 3A

EP 2 202 619 A1

**Description**

The present disclosure relates generally to portable electronic devices that include a touch-sensitive input device and the provision of tactile feedback for such input devices.

Electronic devices, including portable electronic devices, have gained widespread use and can provide a variety of functions including, for example, telephonic, electronic messaging and other personal information manager (PIM) application functions. Portable electronic devices can include several types of devices including mobile stations such as simple cellular telephones, smart telephones, wireless PDAs, and laptop computers with wireless 802.11 or Bluetooth capabilities. Touch-sensitive input devices are useful for input on a portable electronic device.

Devices such as PDAs or smart telephones are generally intended for handheld use and ease of portability. Smaller devices are generally desirable for portability. Touch screen devices constructed of a display, such as a liquid crystal display, with a touch-sensitive overlay are useful on such handheld devices as such handheld devices are small and are therefore limited in space available for user input and output devices. Further, the screen content on the touch screen devices can be modified depending on the functions and operations being performed.

Touch-sensitive input devices suffer from inherent disadvantages relating to user interaction and response. In particular, errors may be made in selecting features using touch-sensitive input devices such as double entry during selection as a result of a lack of touch feedback. While touch screen devices that provide feedback such as audio feedback are known, such devices do not provide a desirable tactile feedback. Further improvements in provision and control of tactile feedback in touch-sensitive devices are desirable.

GENERAL

According to one aspect, there may be provided a method of controlling an electronic device having a touch-sensitive input surface. The method may comprise monitoring the touch-sensitive input surface of a touch event thereon, and modulating a force on the touch-sensitive input surface for causing a first movement of the touch-sensitive input surface relative to a base of the electronic device in response to detection of a touch event on the touch-sensitive input surface. The force may be applied by at least one actuator in a single direction on the touch-sensitive input surface.

Modulating the force on the touch-sensitive input surface for causing the first movement may comprise reducing the force over a collapse time period for causing the touch-sensitive input surface to move toward the base for simulating collapse of a dome-type switch. Modulating the force on the touch-sensitive input surface for causing the first movement may comprise increasing the force on the touch-sensitive input surface, in a direction away from the base, over a ramp-up time period prior to said reducing the force over the collapse time period, the ramp-up time period being longer than the collapse time period.

The method may comprise modulating the force for causing a second movement of the touch-sensitive input surface relative to the base in response to detecting an end of the touch event on the touch-sensitive input surface. Modulating the force for causing the second movement may comprise increasing the force over a release time period for moving the touch-sensitive input surface away from the base for simulating release of the dome-type switch. Modulating the force for causing the second movement may comprise decreasing the force over a ramp-down time period for causing the touch-sensitive input surface to move toward the base after increasing the force over the release time period, the ramp-down time period being longer than the release time period.

Modulating the force may comprise modulating a charge at at least one piezoelectric actuator disposed between the base and the touch-sensitive input surface. Modulating the charge may include modulating a respective charge at each of a plurality of piezoelectric actuators. Each piezoelectric actuator may comprise a piezoelectric disk adhered to an elastically deformable substrate for deforming to cause the first movement.

Monitoring may comprise monitoring an external applied force on the touch-sensitive input surface and modulating the force on the touch-sensitive input surface for causing the first movement may include modulating the force in response to determining the external applied force on the touch-sensitive input surface exceeds a threshold force. Monitoring the force may comprise monitoring a force at at least one force-sensing resistor disposed between the touch-sensitive input surface and the base.

The touch-sensitive input surface may be disposed on an LCD display for providing a touch screen display and the method may comprise rendering a graphical user interface including at least one user-selectable feature on the touch screen display. Modulating the force on the touch-sensitive input surface for causing the first movement may be carried out in response to detection of the touch event if the touch event is determined to occur at the at least one user-selectable feature.

According to another aspect, there may be provided an electronic device comprise a base, a touch-sensitive input surface spaced from and moveable relative to the base, and an actuating arrangement comprising a piezoelectric actuator between the base and the touch-sensitive input surface for modulation of a force on the touch-sensitive input surface for causing a first movement of the touch-sensitive input surface relative to the base in response to detection of a touch event on the touch-sensitive input surface. The force is applied by the actuator in a single direction on the touch-sensitive input surface.

The electronic device may comprise at least one force sensor disposed between the base and the touch-sensitive input surface for detecting a force on the touch-sensitive input surface. The electronic device may also include a display on which the touch-sensitive input surface is disposed for providing a touch screen display.

According to yet another aspect, there may be provided a computer-readable medium having computer-readable code embodied therein for execution by a processor in an electronic device having a touch-sensitive input surface, for monitoring the touch-sensitive input surface for a touch event thereon and modulating a force on the touch-sensitive input surface for causing a first movement of the touch-sensitive input surface relative to a base of the electronic device in response to detection of a touch event on the touch-sensitive input surface. The force may be applied by at least one actuator in a single direction on the touch-sensitive input surface.

Advantageously, the force on the touch-sensitive input surface, which may be a touch screen display, by the piezoelectric actuator can be controlled to provide tactile feedback for the user in the form of forces opposing an externally applied force (by a user's finger) and resulting in movement of the touch screen display. The piezoelectric actuators may be cycled once when the touch is detected to increase the force when the touch is detected and to decrease the force applied to the touch screen display. Further, the applied force on the touch-sensitive overlay of the touch screen display may be applied in one direction by the piezoelectric actuators. Thus, the tactile feedback can be controlled such that feedback provided in response to determination of a touch event and the force and resulting movement of the touch-sensitive input surface can be controlled to simulate the force and resulting movement of a mechanical switch such as a dome-type switch. Thus, a desired tactile feedback, recognizable by a user, is provided using a piezoelectric actuator that includes a piezoelectric disk. The charge at the piezoelectric actuator can be controlled to control the force and provide the desirable tactile feedback upon detection of a touch-input at the touch screen display. Current or voltage may be applied over a controlled period of time to build up capacitive charge to apply a bending force to a mounting disk on which the piezoelectric disk is adhered and to thereby cause movement of the touch-sensitive input surface. Capacitance may then be discharged over a controlled period of time to cause or permit movement of the touch screen display. Thus, tactile feedback may be provided for touch events at specific areas on the touch screen display such that touching the touch screen display at an area that does not correspond to a virtual button or feature, for example, does not result in provision of tactile feedback while touching the touch screen display at an area that corresponds to a virtual button or feature results in provision of such tactile feedback. Further, the tactile feedback may be provided in response to determination of an externally applied force that exceeds a threshold. Thus, tactile feedback is provided when the user touches the touch screen display with sufficient force to exceed the threshold.

The actuating arrangement with the piezoelectric disk may provide desirable tactile feedback in response to a touch event on the touch screen display. Controlling the piezoelectric actuator or actuators to simulate actuation of a dome-type switch upon touching the touch-sensitive input surface may provide a desirable tactile feedback for confirming receipt of input to the user, thereby providing a positive response and reducing the chance of input errors such as double entry, decreasing use time and increasing user-satisfaction. Further, the piezoelectric disk may be thin, therefore not adding significantly to the thickness of the device while providing a desirable tactile feedback to the user.

## BRIEF DESCRIPTION OF THE DRAWINGS

Embodiments of the present disclosure will now be described, by way of example only, with reference to the attached Figures, wherein:

Figure 1 is a simplified block diagram of components including internal components of a portable electronic device according an aspect of an embodiment;

Figure 2 is a front view of an example of a portable electronic device in a portrait orientation;

Figure 3A is a sectional side view of portions of the touch screen display unit of Figure 2;

Figure 3B is a sectional side view of portions of the touch screen display unit of Figure 2;

Figure 3C is a side view of a portion of the portable electronic device of Figure 2 according to one embodiment;

Figure 4 is a front view of an example of a portable electronic device in a portrait orientation, showing hidden detail in ghost outline;

Figure 5 is a functional block diagram of an actuating arrangement of the portable electronic device;

Figure 6 is a flow-chart illustrating a method of controlling a portable electronic device including a touch-sensitive input surface according to an embodiment;

Figure 7 is a simplified example of a graph of voltage across a piezoelectric disk versus time during operation of the portable electronic device according to one example of the embodiment of Figure 6;

Figure 8 is a flow chart illustrating a method of controlling a portable electronic device including a touch-sensitive input surface according to another embodiment;

Figure 9 is a simplified example of a graph of voltage across a piezoelectric disk versus time during operation of the portable electronic device according to one example of the embodiment of Figure 8;

Figure 10 is a flow chart illustrating a method of controlling the portable electronic device according to another embodiment;

Figure 11A is a top view of a portion of another portable electronic device in accordance with another embodiment.

Figures 11B and 11C are side views of portions of the portable electronic device of Figure 11A.

**DESCRIPTION OF PREFERRED EMBODIMENTS**

It will be appreciated that for simplicity and clarity of illustration, where considered appropriate, reference numerals may be repeated among the figures to indicate corresponding or analogous elements. In addition, numerous specific details are set forth in order to provide a thorough understanding of the embodiments described herein. However, it will be understood by those of ordinary skill in the art that the embodiments described herein may be practiced without these specific details. In other instances, well-known methods, procedures and components have not been described in detail so as not to obscure the embodiments described herein. Also, the description is not to be considered as limited to the scope of the embodiments described herein.

The disclosure generally relates to an electronic device, which in the embodiments described herein is a portable electronic device. Examples of portable electronic devices include mobile, or handheld, wireless communication devices such as pagers, cellular phones, cellular smart-phones, wireless organizers, personal digital assistants, wirelessly enabled notebook computers and the like.

The portable electronic device may be a two-way communication device with advanced data communication capabilities including the capability to communicate with other portable electronic devices or computer systems through a network of transceiver stations. The portable electronic device may also have the capability to allow voice communication. Depending on the functionality provided by the portable electronic device, it may be referred to as a data messaging device, a two-way pager, a cellular telephone with data messaging capabilities, a wireless Internet appliance, or a data communication device (with or without telephony capabilities). The portable electronic device may also be a portable device without wireless communication capabilities as a handheld electronic game device, digital photograph album, digital camera and the like.

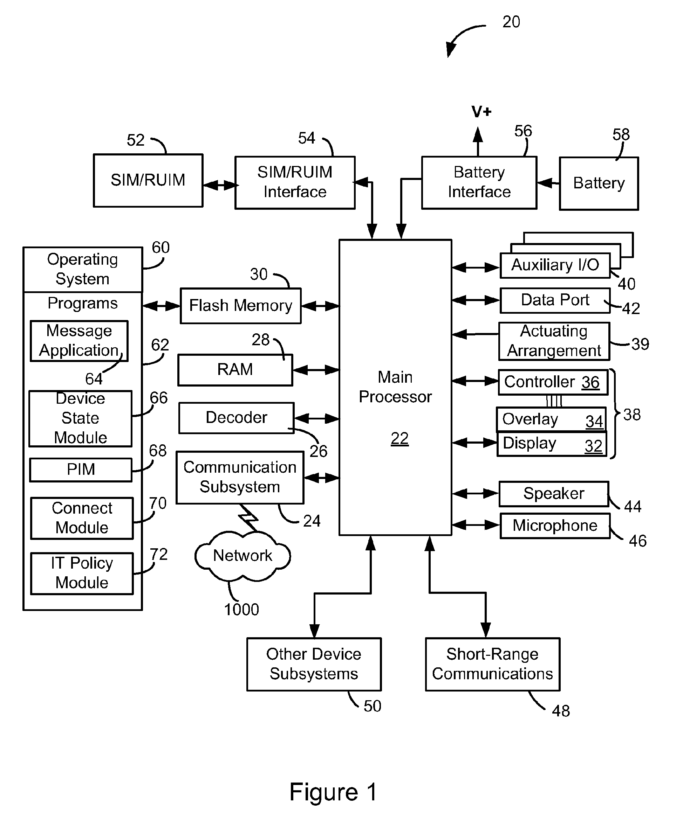

Referring to Figure 1, there is shown therein a block diagram of an example of an embodiment of a portable electronic device 20. The portable electronic device 20 includes a number of components such as the processor 22 that controls the overall operation of the portable electronic device 20. Communication functions, including data and voice communications, are performed through a communication subsystem 24. Data received by the portable electronic device 20 can be decompressed and decrypted by a decoder 26, operating according to any suitable decompression techniques (e.g. YK decompression, and other known techniques) and encryption techniques (e.g. using an encryption technique such as Data Encryption Standard (DES), Triple DES, or Advanced Encryption Standard (AES)). The communication subsystem 24 receives messages from and sends messages to a wireless network 1000. In this example of the portable electronic device 20, the communication subsystem 24 is configured in accordance with the Global System for Mobile Communication (GSM) and General Packet Radio Services (GPRS) standards. The GSM/GPRS wireless network is used worldwide and it is expected that these standards will be superseded eventually by Enhanced Data GSM Environment (EDGE) and Universal Mobile Telecommunications Service (UMTS). New standards are still being defined, but it is believed that they will have similarities to the network behavior described herein, and it will also be understood by persons skilled in the art that the embodiments described herein are intended to use any other suitable standards that are developed in the future. The wireless link connecting the communication subsystem 24 with the wireless network 1000 represents one or more different Radio Frequency (RF) channels, operating according to defined protocols specified for GSM/GPRS communications. With newer network protocols, these channels are capable of supporting both circuit switched voice communications and packet switched data communications.

Although the wireless network 1000 associated with the portable electronic device 20 is a GSM/GPRS wireless network in one example of an implementation, other wireless networks may also be associated with the portable electronic device 20 in variant implementations. The different types of wireless networks that may be employed include, for example, data-centric wireless networks, voice-centric wireless networks, and dual-mode networks that can support both voice and data communications over the same physical base stations. Combined dual-mode networks include, but are not limited to, Code Division Multiple Access (CDMA) or CDMA2000 networks, GSM/GPRS networks (as mentioned above), and future third-generation (3G) networks like EDGE and UMTS. Some other examples of data-centric networks include WiFi 802.11, Mobite™ and DataTAC™ network communication systems. Examples of other voice-centric data networks include Personal Communication Systems (PCS) networks like GSM and Time Division Multiple Access (TDMA) systems.

The processor 22 also interacts with additional subsystems such as a Random Access Memory (RAM) 28, a flash memory 30, a display 32 with a touch-sensitive input surface in the form of a touch-sensitive overlay 34 connected to an electronic controller 36 that together make up a touch screen display 38, an auxiliary input/output (I/O) subsystem 40, a data port 42, a speaker 44, a microphone 46, short-range communications 48 and other device subsystems 50. The touch-sensitive overlay 34 and the electronic controller 36 provide a touch-sensitive input device and the processor 22 interacts with the touch-sensitive overlay 34 via the electronic controller 36. An actuating arrangement 39 is connected to and communicates with the processor 22.

Some of the subsystems of the portable electronic device 20 perform communication-related functions, whereas other subsystems may provide "resident" or on-device functions. By way of example, the display 32 and the touch-sensitive overlay 34 may be used for both communication-related functions, such as entering a text message for transmission over the network 1000, and device-resident functions such as a calculator or task list.

The portable electronic device 20 can send and receive communication signals over the wireless network 1000 after network registration or activation procedures have been completed. Network access is associated with a subscriber or user of the portable electronic device 20. To identify a subscriber according to the present embodiment, the portable electronic device 20 uses a SIM/RUIM card 52 (i.e. Subscriber Identity Module or a Removable User Identity Module) inserted into a SIM/RUIM interface 54 for communication with a network such as the network 1000. The SIM/RUIM card 52 is one type of a conventional "smart card" that can be used to identify a subscriber of the portable electronic device 20 and to personalize the portable electronic device 20, among other things. In the present embodiment the portable electronic device 20 is not fully operational for communication with the wireless network 1000 without the SIM/RUIM card 52. By inserting the SIM/RUIM card 52 into the SIM/RUIM interface 54, a subscriber can access all subscribed services. Services may include: web browsing and messaging such as e-mail, voice mail, Short Message Service (SMS), and Multimedia Messaging Services (MMS). More advanced services may include: point of sale, field service and sales force automation. The SIM/RUIM card 52 includes a processor and memory for storing information. Once the SIM/RUIM card 52 is inserted into the SIM/RUIM interface 54, it is coupled to the processor 22. In order to identify the subscriber, the SIM/RUIM card 52 can include some user parameters such as an International Mobile Subscriber Identity (IMSI). An advantage of using the SIM/RUIM card 52 is that a subscriber is not necessarily bound by any single physical portable electronic device. The SIM/RUIM card 52 may store additional subscriber information for a portable electronic device as well, including datebook (or calendar) information and recent call information. Alternatively, user identification information can also be programmed into the flash memory 30.

The portable electronic device 20 is a battery-powered device and includes a battery interface 56 for receiving one or more rechargeable batteries 58. In at least some embodiments, the battery 58 can be a smart battery with an embedded microprocessor. The battery interface 56 is coupled to a regulator (not shown), which assists the battery 58 in providing power V+ to the portable electronic device 20. Although current technology makes use of a battery, future technologies such as micro fuel cells may provide the power to the portable electronic device 20.

The portable electronic device 20 also includes an operating system 60 and software components 62 which are described in more detail below. The operating system 60 and the software components 62 that are executed by the processor 22 are typically stored in a persistent store such as the flash memory 30, which may alternatively be a read-only memory (ROM) or similar storage element (not shown). Those skilled in the art will appreciate that portions of the operating system 60 and the software components 62, such as specific software applications 64, 66, 68, 70 and 72, or parts thereof, may be temporarily loaded into a volatile store such as the RAM 28. Other software components can also be included, as is well known to those skilled in the art.

The subset of software components 62 that control basic device operations, including data and voice communication applications, will normally be installed on the portable electronic device 20 during manufacture of the portable electronic device 20. Other software applications include a message application 64 that can be any suitable software program that allows a user of the portable electronic device 20 to send and receive electronic messages. Various alternatives exist for the message application 64 as is well known to those skilled in the art. Messages that have been sent or received by the user are typically stored in the flash memory 30 of the portable electronic device 20 or some other suitable storage element in the portable electronic device 20. In at least some embodiments, some of the sent and received messages may be stored remotely from the device 20 such as in a data store of an associated host system that the portable electronic device 20 communicates with.

The software components 62 can further include a device state module 66, a Personal Information Manager (PIM) 68, and other suitable modules (not shown). The device state module 66 provides persistence, i.e. the device state module 66 ensures that important device data is stored in persistent memory, such as the flash memory 30, so that the data is not lost when the portable electronic device 20 is turned off or loses power.

The PIM 68 includes functionality for organizing and managing data items of interest to the user, such as, but not limited to, e-mail, contacts, calendar events, voice mails, appointments, and task items. The PIM 68 has the ability to send and receive data items via the wireless network 1000. PIM data items may be seamlessly integrated, synchronized, and updated via the wireless network 1000 with the portable electronic device subscriber's corresponding data items stored and/or associated with a host computer system. This functionality creates a mirrored host computer on the portable electronic device 20 with respect to such items. This can be particularly advantageous when the host computer system is the portable electronic device subscriber's office computer system.

The software components 62 also includes a connect module 70, and an information technology (IT) policy module 72. The connect module 70 implements the communication protocols that are required for the portable electronic device 20 to communicate with the wireless infrastructure and any host system, such as an enterprise system, that the portable electronic device 20 is authorized to interface with.

The connect module 70 includes a set ofAPIs that can be integrated with the portable electronic device 20 to allow the portable electronic device 20 to use any number of services associated with the enterprise system. The connect module 70 allows the portable electronic device 20 to establish an end-to-end secure, authenticated communication pipe with the host system. A subset of applications for which access is provided by the connect module 70 can be used to pass IT policy commands from the host system to the portable electronic device 20. This can be done in a wireless or wired manner. These instructions can then be passed to the IT policy module 72 to modify the configuration of the device 20. Alternatively, in some cases, the IT policy update can also be done over a wired connection.

Other types of software applications can also be installed on the portable electronic device 20. These software applications can be third party applications, which are added after the manufacture of the portable electronic device 20. Examples of third party applications include games, calculators, utilities, etc.

The additional applications can be loaded onto the portable electronic device 20 through at least one of the wireless network 1000, the auxiliary I/O subsystem 40, the data port 42, the short-range communications subsystem 48, or any other suitable device subsystem 50. This flexibility in application installation increases the functionality of the portable electronic device 20 and may provide enhanced on-device functions, communication-related functions, or both. For example, secure communication applications may enable electronic commerce functions and other such financial transactions to be performed using the portable electronic device 20.

The data port 42 enables a subscriber to set preferences through an external device or software application and extends the capabilities of the portable electronic device 20 by providing for information or software downloads to the portable electronic device 20 other than through a wireless communication network. The alternate download path may, for example, be used to load an encryption key onto the portable electronic device 20 through a direct and thus reliable and trusted connection to provide secure device communication.

The data port 42 can be any suitable port that enables data communication between the portable electronic device 20 and another computing device. The data port 42 can be a serial or a parallel port. In some instances, the data port 42 can be a USB port that includes data lines for data transfer and a supply line that can provide a charging current to charge the battery 58 of the portable electronic device 20.

The short-range communications subsystem 48 provides for communication between the portable electronic device 20 and different systems or devices, without the use of the wireless network 1000. For example, the short-range communications subsystem 48 may include an infrared device and associated circuits and components for short-range communication. Examples of short-range communication standards include standards developed by the Infrared Data Association (IrDA), Bluetooth, and the 802.11 family of standards developed by IEEE.

In use, a received signal such as a text message, an e-mail message, or web page download is processed by the communication subsystem 24 and input to the processor 22. The processor 22 then processes the received signal for output to the display 32 or alternatively to the auxiliary I/O subsystem 40. A subscriber may also compose data items, such as e-mail messages, for example, using the touch-sensitive overlay 34 on the display 32 that are part of the touch screen display 38, and possibly the auxiliary I/O subsystem 40. The auxiliary subsystem 40 may include devices such as: a mouse, track ball, infrared fingerprint detector, or a roller wheel with dynamic button pressing capability. A composed item may be transmitted over the wireless network 1000 through the communication subsystem 24.

For voice communications, the overall operation of the portable electronic device 20 is substantially similar, except that the received signals are output to the speaker 44, and signals for transmission are generated by the microphone 46. Alternative voice or audio I/O subsystems, such as a voice message recording subsystem, can also be implemented on the portable electronic device 20. Although voice or audio signal output is accomplished primarily through the speaker 44, the display 32 can also be used to provide additional information such as the identity of a calling party, duration of a voice call, or other voice call related information.

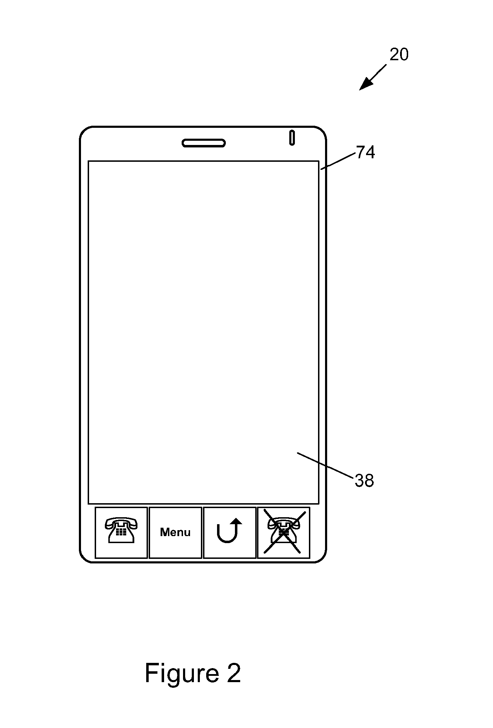

Reference is first made to the Figure 2 which shows a front view of an example of a portable electronic device 20 in portrait orientation. The portable electronic device 20 includes a housing 74 that houses the internal components that are shown in Figure 1 and frames the touch screen display 38 such that the touch screen display 38 is exposed for user-interaction therewith when the portable electronic device 20 is in use. It will be appreciated that the touch screen display 38 may include any suitable number of user-selectable features rendered thereon, for example, in the form of virtual buttons for user-selection of, for example, applications, options, or keys of a keyboard for user entry of data during operation of the portable electronic device 20.

The touch screen display 38 can be any suitable touch screen display such as a capacitive touch screen display. A capacitive touch screen display includes the display 32 and the touch-sensitive overlay 34, as shown in Figure 1, in the form of a capacitive touch-sensitive overlay. It will be appreciated that the touch-sensitive overlay 34 in the form of a capacitive touch-sensitive overlay includes a number of layers in a stack and is fixed to the display 32 via a suitable optically clear adhesive. The layers can include, for example a substrate fixed to the LCD display 32 by a suitable adhesive, a ground shield layer, a barrier layer, a pair of capacitive touch sensor layers separated by a substrate or other barrier layer, and a cover layer fixed to the second capacitive touch sensor layer by a suitable adhesive. The capacitive touch sensor layers can be any suitable material such as patterned indium tin oxide (ITO).

In the present example, the X and Y location of a touch event are both determined with the X location determined by a signal generated as a result of capacitive coupling with one of the touch sensor layers and the Y location determined by the signal generated as a result of capacitive coupling with the other of the touch sensor layers. Each of the touch-sensor layers provides a signal to the controller 36 as a result of capacitive coupling with a suitable object such as a finger of a user resulting in a change in the electric field of each of the touch sensor layers. The signals represent the respective X and Y touch location values. It will be appreciated that other attributes of the user's touch on the touch screen display 38 can be determined. For example, the size and the shape of the touch on the touch screen display 38 can be determined in addition to the location (X and Y values) based on the signals received at the controller 36 from the touch sensor layers.

Referring still to Figure 2, it will be appreciated that a user's touch on the touch screen display 38 is determined by determining the X and Y touch location and user-selected input is determined based on the X and Y touch location and the application executed by the processor 22. Thus a feature such as a virtual button displayed on the touch screen display 38 may be selected by matching the feature to the X and Y location of a touch event on the touch screen display 38. A feature selected by the user is determined based on the X and Y touch location and the application.

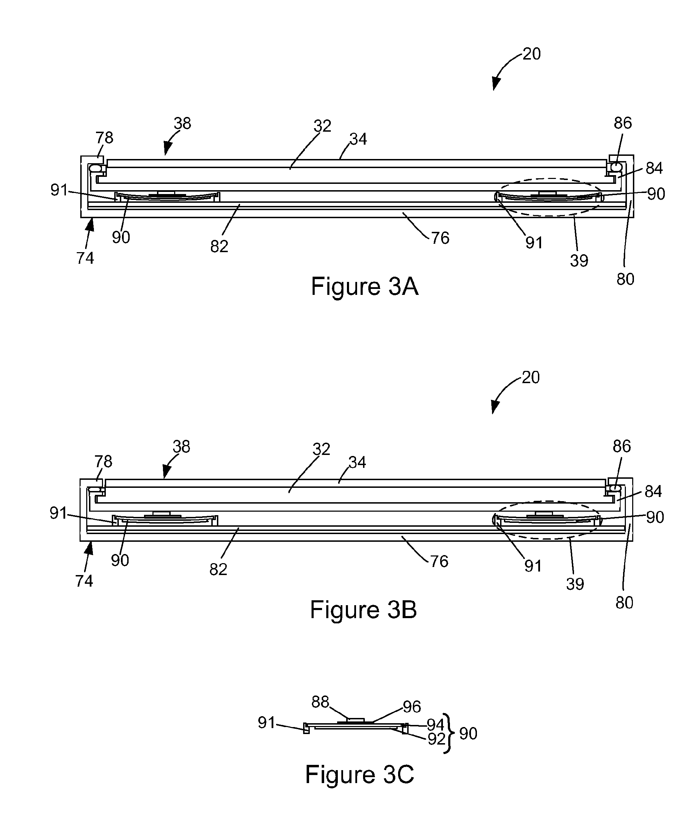

The housing 74 can be any suitable housing for the internal components shown in Figure 1. As best shown in Figures 3A and 3B, the housing 74 in the present example includes a back 76, a frame 78, which frames the touch screen display 38 and sidewalls 80 that extend between and generally perpendicular to the back 76 and the frame 78. A base 82 is spaced from and is generally parallel to the back 76. The base 82 can be any suitable base and can include, for example, a printed circuit board or flex circuit board supported by a stiff support between the base 82 and the back 76. The back 76 includes a plate (not shown) that is releasably attached for insertion and removal of, for example, the battery 58 and the SIM/RUIM card 52 described above. It will be appreciated that the back 76, the sidewalls 80 and the frame 78 can be injection molded, for example. In the example of the portable electronic device 20 shown in Figure 2, the frame 78 is generally rectangular with rounded corners although other shapes are possible.

The display 32 and the touch-sensitive overlay 34 can be supported on a support tray 84 of suitable material such as magnesium for providing mechanical support to the display 32 and touch-sensitive overlay 34. A compliant gasket 86 can be located around the perimeter of the frame 78, between an upper portion of the support tray 84 and the frame 78 to provide a gasket for protecting the components housed in the housing 74 of the portable electronic device 20. A suitable material for the compliant gasket 86 includes, for example, a cellular urethane foam for providing shock absorption, vibration damping and a suitable fatigue life. The cellular urethane foam may be used to pre-load the piezo disk actuator. The touch screen display 38 is moveable within the housing 74 as the touch screen display 38 can be moved away from the base 82, thereby compressing the compliant gasket 86, for example and can be moved toward the base 82, thereby compressing shock-absorbing elements 88 referred to below. Figures 3A and 3B show exaggerated movement of the touch screen display 38 with Figure 3A showing the touch screen display 38 with an external applied force by a user's finger, for example, during a touch event and with the actuating arrangement 39 absent actuation and with Figure 3B showing the touch screen display 38 with the actuating arrangement 39 actuated during a touch event.

In the present example, the actuating arrangement 39 includes four piezo disk actuators 90, with each piezo disk actuator 90 supported on a respective support ring 91. Each support ring 91 extends from the base 82 toward the touch screen display 38 for supporting the respective piezo disk actuator 90 while permitting flexing of the piezo disk actuator. As best shown in Figure 3C, each piezo disk actuator 90 includes a piezoelectric disk 92 such as a PZT ceramic disk adhered to a metal substrate 94 of larger diameter than the piezoelectric disk 92 for bending when the piezoelectric disk 92 contracts as a result of build up of charge at the piezoelectric disk 92. Each piezo disk actuator 90 is supported on the respective support ring 91 on one side of the base 82, proximal a respective corner of the housing 74 with the metal ring sized such that the edge of the metal substrate 94 contacts the support ring 91 for supporting the piezo disk actuator 90 and permitting flexing of the piezo disk actuator. A shock-absorbing element 88, which in the present example is in the form of a cylindrical shock-absorber of suitable material such as a hard rubber is located between the piezo disk actuator 90 and the support tray 84. A respective force sensor 96 is located between each shock-absorbing element 88 and the respective piezo disk actuator 90. A suitable force sensor 96 includes, for example, a puck-shaped force sensing resistor for measuring applied force (or pressure). It will be appreciated that a force can be determined using a force sensing resistor as an increase in pressure on the force sensing resistor results in a decrease in resistance (or increase in conductance). In the portable electronic device 20, each piezo disk actuator 90 is located between the base 82 and the support tray 84 and force is applied on each piezo disk actuator 90 by the touch screen display 38, in the direction of the base 82, causing bending of the piezo disk actuator 90. Thus, absent an external force applied by the user, for example by pressing on the touch screen display 38, and absent a charge on the piezo disk actuator 90, the piezo disk actuator 90 undergoes slight bending. An external applied force in the form of a user pressing on the touch screen display 38 during a touch event, and prior to actuation of the piezo disk actuator 90, causes increased bending of the piezo disk actuator 90, as shown in Figure 3A and the piezo disk actuator 90 applies a spring force against the touch screen display 38.. When the piezoelectric disk 92 is charged, the piezoelectric disk 92 shrinks and causes the metal substrate 94 and piezoelectric disk 92 to apply a further force, opposing the external applied force, on the touch screen display 38 as the piezo actuator 90 straightens, as shown in Figure 3B.

Each of the piezo disk actuators 90, shock absorbing elements 88 and force sensors 96 are supported on the respective one of the support rings 91 on one side of the base 82. The support rings can be part of the base 82 or can be supported on the base 82. The base 82 can be printed circuit board while the opposing side of the base 82 provides mechanical support and electrical connection for other components (not shown) of the portable electronic device 20. Each piezo disk actuator 90 is located between the base 82 and the support tray 84 such that an external applied force on the touch screen display 38 resulting from a user pressing the touch screen display 38 can be measured by the force sensors 96 and such that the charging of the piezo disk actuator 90 causes a force on the touch screen display 38, away from the base 82.

In the present embodiment each piezo disk actuator 90 is in contact with the support tray 84. Thus, depression of the touch screen display 38 by user application of a force thereto is determined by a change in resistance at the force sensors 96 and causes further bending of the piezo disk actuators 90 as shown in Figure 3A. Further, the charge on the piezo disk actuator 90 can be modulated to control the force applied by the piezo disk actuator 90 on the support tray 84 and the resulting movement of the touch screen display 38. The charge can be modulated by modulating the applied voltage or current. For example, a current can be applied to increase the charge on the piezo disk actuator 90 to contract the piezoelectric disk 92 as described above, causing the metal substrate 94 and the piezoelectric disk 92 to straighten as referred to above. This charge therefore results in the force on the touch screen display 38 for opposing the external applied force and movement of the touch screen display 38 away from the base 82, as shown in Figure 3B. The charge on the piezo disk actuator 90 can also be removed via a controlled discharge current causing the piezoelectric disk 92 to expand again, releasing the force caused by the electric charge and thereby decreasing the force on the touch screen display 38, permitting the touch screen display to return to a rest position. The movement of the touch screen display 38 and the flexing of the piezo disk actuators 90 is exaggerated in Figures 3A and 3B for the purpose of illustration.

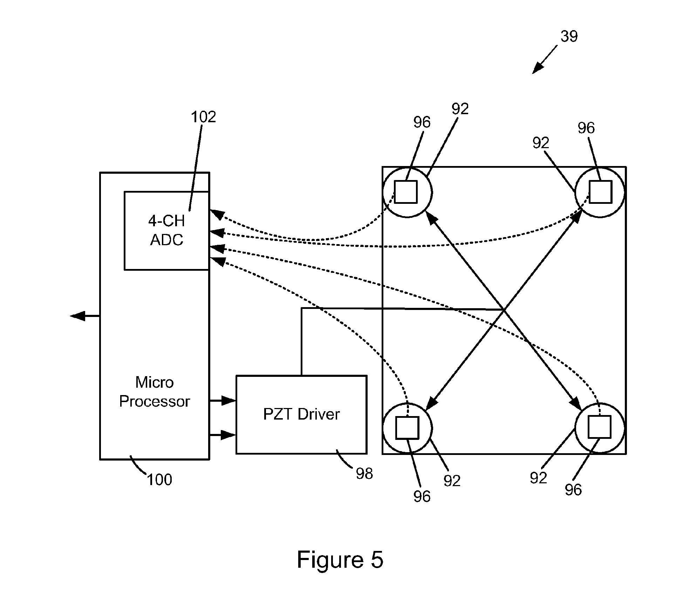

Figure 5 shows the actuating arrangement 39 according to one embodiment. As shown, each of the piezoelectric disks 92 is connected to a piezo driver 98 that communicates with a microprocessor 100 including a four-channel amplifier and analog-to-digital converter 102 that is connected to each of the force sensors 96. The microprocessor 100 is also in communication with the main processor 22 of the portable electronic device 20. The microprocessor 100 can provide signals to the main processor 22 of the portable electronic device 20. It will be appreciated that the piezo driver 98 can be embodied in drive circuitry between the microprocessor 100 and the piezoelectric disks 92.

The mechanical work performed by the piezo disk actuator 90 can be controlled to provide generally consistent force and movement of the touch screen display 38 in response to detection of an applied force on the touch screen display 38 in the form of a touch, for example. Fluctuations in mechanical work performed as a result of, for example, temperature, can be reduced by modulating the current to control the charge. Those skilled in the art will appreciate that each piezoelectric disk 92 has similar electrical properties to a capacitor. The mechanical work performed (force * displacement) by the peizo disk actuator 90 can be controlled by controlling the charge, expressed as:

$$Q_{piezo} = C_{piezo} * V_{piezo}$$

where:

Q is charge;
C is capacitance; and
V is voltage.

A coefficient, referred to as the D31 coefficient of a piezoelectric material composition provides the relationship between voltage and force. The D31 coefficient and the relative dielectric constant, (Er) of a given piezoelectric material composition vary inversely with temperature, however. Therefore, if the charge of the piezoelectric disk 92 is controlled within a small range, the variance of the mechanical work of the piezo disk actuator 90 can be small. The current can be controlled as the current flowing in or out of a capacitor (which has similar electrical properties to the piezoelectric disk 92) is given by:

$$I = C * dV / dT$$

where

I is current;
C is capacitance; and
dV/dT is differential voltage or instantaneous rate of
voltage change.

With I and dT held constant, then as C decreases, dV increases. Thus the charge is controlled since $Q_{piezo} = C_{piezo} * V_{piezo}.$

The microprocessor 100 controls the PZT driver 98 for controlling the current to the piezoelectric disks 92 and thereby controlling the charge, increasing the charge to increase the force on the touch screen display 38 away from the base 82 and decreasing the charge to decrease the force on the touch screen display 38, permitting the touch screen display 38 to move toward the base 82. In the present example, each of the piezo disk actuators 90 are connected to the microprocessor 100 through the piezo driver 98 and are all controlled equally and concurrently. It will be appreciated that the piezo disk actuators 90 can be controlled separately, however.

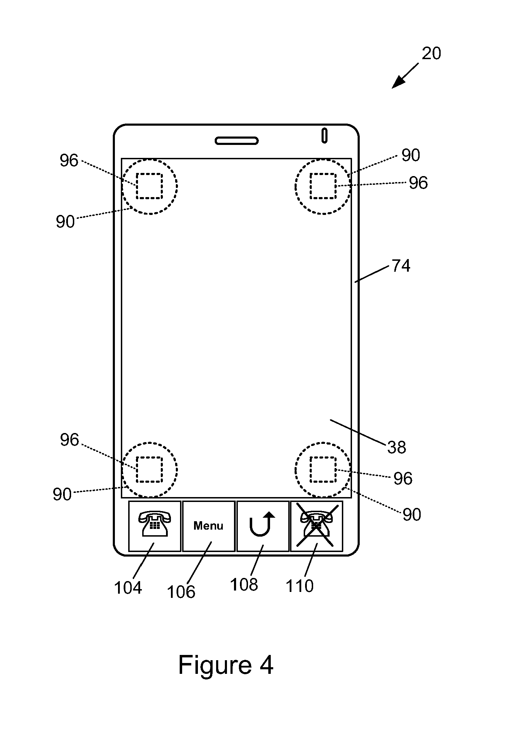

In the present example, the piezo disk actuators 90 are each located proximal a respective corner of the touch screen display 38, as shown in Figure 4. The portable electronic device 20 can also include physical buttons. In the present example, the portable electronic device 20 includes four physical buttons 104, 106, 108, 110 in the housing 74 for user-selection for performing functions or operations including an "off-hook" button 104 for placing an outgoing cellular telephone call or receiving an incoming cellular telephone call, a Menu button 106 for displaying a context-sensitive menu or submenu, an escape button 108 for returning to a previous screen or exiting an application, and an "on-hook" button 110 for ending a cellular telephone call. Further buttons for performing further functions on the portable electronic device of Figure 4 may be virtual features rendered on the touch screen display 38.

The portable electronic device 20 is controlled generally by monitoring the touch screen display 38 for a touch event thereon, and modulating a force on the touch screen display 38 for causing a first movement of the touch screen display 38 relative to the base 82 of the portable electronic device 20 in response to detection of a touch event. The force is applied by at least one of the piezo disk actuators 90, in a single direction on the touch-sensitive input surface of the touch screen display 38.

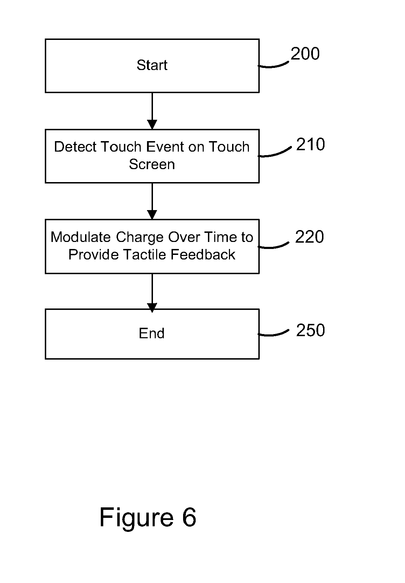

Reference is made to Figure 6 to describe a method of controlling a portable electronic device in accordance with one embodiment. It will be appreciated that the steps of Figure 6 can be carried out by routines or subroutines of software executed by, for example, the microprocessor 100. Coding of software for carrying out such steps is well within the scope of a person of ordinary skill in the art having regard to the present description.

The method starts with, for example, the portable electronic device 20 turned to an on or awake state (step 200). The touch-sensitive input surface of the touch screen display 38 is monitored for a touch event (step 210) and, in response to determination of a touch event, the charge at each of the piezoelectric disks 92 is modulated to modulate the force applied by the piezoelectric actuator 90 on the touch screen display 38 and cause movement of the touch screen display 38 for simulating the collapse of a dome-type switch (step 220). The process ends at step 250.

It will be appreciated that the flow chart of Figure 6 is simplified for the purpose of explanation. A further touch event can be detected again and the steps can be repeated, for example. Further, the charge at each of the piezoelectric disks 92 can be modulated independently, for example, to modulate the force applied by any one or any combination of the piezoelectric actuators 90 to the touch screen display 38 to cause movement of the touch screen display 38 for simulating another collapse of a dome-type switch prior to the end of the first touch event being detected.

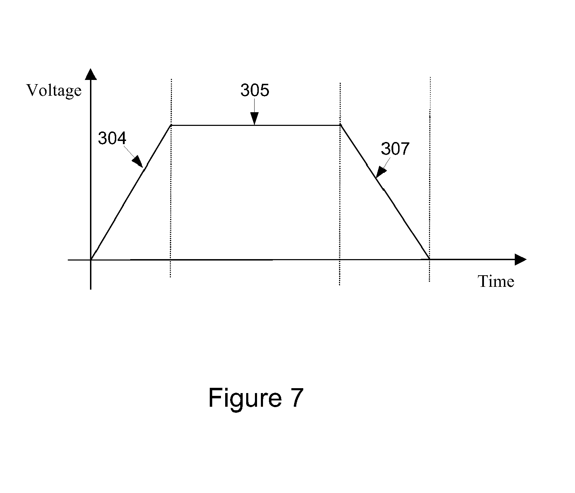

Continued reference is made to Figure 6 to describe an example of the method of controlling a portable electronic device in accordance with the present embodiment. Reference is also made to Figure 7, which shows a simplified example of a graph of voltage across the piezoelectric disk 92 versus time during operation of the portable electronic device 20. It will be appreciated that the voltage is the voltage across one of the piezoelectric disks 92, which is related to the charge at the piezoelectric disk 92. This example shown in Figure 7 is intended to be illustrative only and is not intended to limit the scope of the present disclosure.

The portable electronic device 20 is turned to an on or awake state in any suitable manner (step 200). In the on or awake state, user-selectable features are rendered on the touch screen display 38. Such user-selectable features can include, for example, icons for selection of an application for execution by the processor 22, buttons for selection of user options, keys of a virtual keyboard, keypad or any other suitable user-selectable icons or buttons.

A force on the touch screen display 38 is detected through the force sensors 96, as a result of a change in resistance at the force sensitive resistors. The force is determined at the microprocessor 100 as a result of signals from the amplifier and four-channel analog to digital converter 102 connected to each of the force sensors 96. Thus, the touch screen display 38 is monitored for a touch event and a touch event on the touch screen display 38 can be detected. Such a touch event can be determined upon determination of an external applied force as a result of a user touch at the touch screen display 38 for selection of, for example, an Internet browser application, an email application, a calendar application, or any other suitable application, option, or other feature within an application (step 210). For the purpose of the present example, the touch event is detected when the force measured at the force sensors 96 exceeds a minimum threshold force. Thus, the measured force at the force sensors 96 is compared to a threshold force and a touch event is detected if the measured force is determined to exceed the threshold force. Conversely, a touch event is not detected as a result of a relatively light touch or brush on the touch screen display 38 with a measured force that is lower than the threshold force. It will be appreciated that the touch-sensitive input surface 34 is thereby monitored for a touch event.

Between the time that the threshold force is exceeded at step 202 and the modulation of the charge at the piezo disk actuators 90, there may be a time delay. In the present embodiment, the delay is due only to the short time period for communication between the force sensors 96, the four-channel amplifier and analog-to-digital converter 102, the microprocessor 100, the piezo driver 98, and the piezoelectric disks 92. In other embodiments, a further delay may be added to provide a different feel for the user.

In response to detection of the touch event at step 202, a suitable current is applied to the piezo disk actuator 90, ramping up the charge over a period of time causing flexing of the piezo disk actuator 90 and a resulting force applied to the touch screen display 38 through the support tray 84. The force applied by each piezo disk actuator 90 is in the same direction, substantially perpendicularly away from the base 82, and each piezo disk actuator 90 applies the force to the touch screen display 38 in the same direction each time a force is applied. Figure 7 shows a voltage increase over time at the line on the graph indicated by the numeral 304, as a result of applied current to charge each piezoelectric disk 92. The portion of the graph indicated by the numeral 304 is shown as being a straight line. It is not necessary that the line be straight, however, as the ramp-up may take any suitable shape. The time of charge may be from about 100μs to about 50ms, for example. A charge time of about 10ms to about 50ms is difficult to perceive by the user touching the touch screen display 38.

The voltage can be held as shown in the portion of the graph indicated by the numeral 305 to hold the charge or provide a delay prior to discharge. The delay can be in the range of about 10ns to about 50ms.

Next, the electrical charge is reduced by a suitable controlled discharge current and the resulting force applied by the piezo disk actuator 90 on the touch screen display 38 is reduced over a period of time (step 220). The voltage decreases over time at the line on the graph indicated by the numeral 307, as a result of a suitable discharge current applied to each piezoelectric disk 92. The portion of the graph indicated by the numeral 307 is shown as being a straight line. It is not necessary that the line be straight, however, as the discharge may take any suitable shape. The time of discharge may be from about 100μs to about 50ms, for example. A charge time in the range of about 100μs to about 10ms provides a tactile feel simulating collapse of a dome-type switch for the user touching the touch screen display 38.

The graph shown in Figure 7 illustrates one charge cycle with a single charge and a single discharge. A single charge cycle simulates a mechanical switch response, providing tactile feedback to the user. Although the increase in charge and decrease in charge are represented as being symmetrical in Figure 7, the increase and decrease need not be symmetrical. The charge may be ramped up over a period of time so that the user does not detect the force applied by the piezo disk actuators 90 on the touch screen display 38. The electrical charge may be reduced by a suitable controlled discharge current and the resulting force applied by the piezo disk actuator 90 on the touch screen display 38 is reduced over a very short period of time relative to the period of time for ramping up the charge, for simulating collapse of a dome-type switch (step 220). This accentuates the movement simulating the collapse of the dome-type switch. The peak current for charging the piezo can be lower since the piezo is a capacitor and therefore the slower the charge is applied, the lower the current that is required. This permits the use of smaller size and lower cost electronics.

The charge and/or discharge current applied to the piezoelectric disk 92 is therefore modulated to modulate the force from the piezo disk actuators 90 on the touch screen display 38 for providing a desirable tactile feedback by simulating collapse of a dome-type switch in response to detection of the touch event and by simulating release of a dome-type switch upon detection of an end of the touch event.

The process ends at step 250.

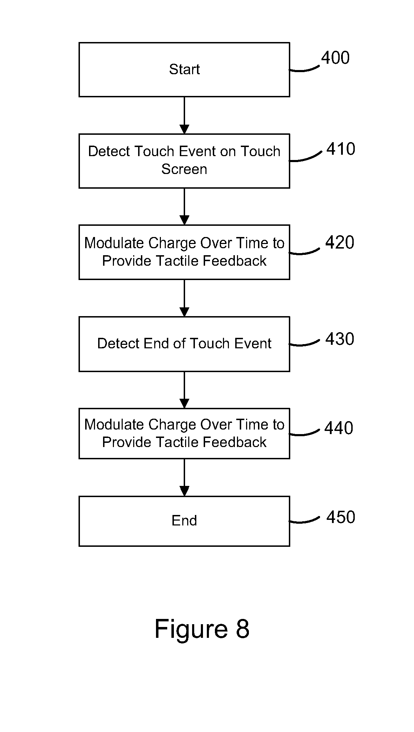

Referring to Figure 8, there is shown a method of controlling a portable electronic device in accordance with another embodiment. It will be appreciated that the steps of Figure 8 can be carried out by routines or subroutines of software executed by, for example, the microprocessor 100. Coding of software for carrying out such steps is well within the scope of a person of ordinary skill in the art having regard to the present description.

The method starts with, for example, the portable electronic device 20 turned to an on or awake state (step 400). The touch screen display 38 is monitored for a touch event (step 410) and, in response to determination of a touch event, the charge at each of the piezoelectric disks 92 is modulated to modulate the force applied by the piezoelectric actuator 90 on the touch screen display 38 to cause movement of the touch screen display 38 for simulating the collapse of a dome-type switch (step 420). When the end of the touch event is detected (step 430), the charge at each of the piezoelectric disks 92 is modulated to modulate the force applied by the piezoelectric actuators 90 to the touch screen display 38 to cause movement of the touch screen display 38 for simulating release of a dome-type switch (step 440). The process ends at step 450. The force is applied by at least one of the piezoelectric actuators 90 in a one direction on the touch-sensitive input surface of the touch screen display 38.

It will be appreciated that the flow chart of Figure 8 is simplified for the purpose of explanation. A further touch event can be detected again and the steps can be repeated, for example. Further, more than one touch event can occur such that a second touch event can be detected prior to the end of a first touch event. Thus, the charge at each of the piezoelectric disks 92 can be modulated again to modulate the force applied by the piezoelectric actuators 90 to the touch screen display 38 to cause movement of the touch screen display 38 for simulating another collapse of a dome-type switch prior to the end of the first touch event being detected. Similarly, the end of a first one of the touch events can be detected and the charge at each of the piezoelectric disks 92 modulated to modulate the force applied by the piezoelectric actuators 90 to cause movement of the touch screen display 38 for simulating release of a dome-type switch followed by the end of the second one of the touch events being detected and the charge at each of the piezoelectric disks 92 again modulated to modulate the force applied by the piezoelectric actuators and cause movement of the touch screen display 38 for simulating release of a dome-type switch. Therefore, collapse of a dome-type switch can be simulated multiple times in succession prior to simulation of release of a dome-type switch being simulated. The release can also be simulated multiple times in succession. The successive simulations can occur rapidly. Further still, multiple dome-type switch collapses in succession can be simulated based on the external applied force. For example, a first simulation of collapse of a dome-type switch can occur at a threshold external applied force and a second simulation of collapse of a dome-type switch can occur at a second, higher threshold external applied force to provide multiple collapse events.

Continued reference is made to Figure 8 to describe an example of the method of controlling a portable electronic device in accordance with the present embodiment. The portable electronic device 20 is turned to an on or awake state in any suitable manner (step 400). In the on or awake state, user-selectable features are rendered on the touch screen display 38. Such user-selectable features can include, for example, icons for selection of an application for execution by the processor 22, buttons for selection of user options, keys of a virtual keyboard, keypad or any other suitable user-selectable icons or buttons.

A force on the touch screen display 38 is detected through the force sensors 96, as a result of a change in resistance at the force sensitive resistors. The force is determined at the microprocessor 100 as a result of signals from the amplifier and four-channel analog to digital converter 102 connected to each of the force sensors 96. Thus, the touch screen display 38 is monitored for a touch event and a touch event on the touch screen display 38 can be detected. Such a touch event can be determined upon determination of an external applied force as a result of a user touch at the touch screen display 38 for selection of, for example, an Internet browser application, an email application, a calendar application, or any other suitable application, option, or other feature within an application (step 410). For the purpose of the present example, the touch event is detected when the force measured at the force sensors 96 exceeds a minimum threshold force. Thus, the measured force at the force sensors 96 is compared to a threshold force and a touch event is detected if the measured force is determined to exceed the threshold force. Conversely, a touch event is not detected as a result of a relatively light touch or brush on the touch screen display 38 with a measured force that is lower than the threshold force. It will be appreciated that the touch-sensitive input surface 34 is thereby monitored for a touch event.

In response to detection of the touch event at step 410, a suitable current is applied to the piezo disk actuator 90, ramping up the charge over a period of time causing flexing of the piezo disk actuator 90 and a resulting force applied to the touch screen display 38 through the support tray 84. The charge is ramped up over a period of time so that the user does not detect the force applied by the piezo disk actuators 90 on the touch screen display 38. Next, the electrical charge is reduced by a suitable controlled discharge current and the resulting force applied by the piezo disk actuator 90 on the touch screen display 38 is reduced over a very short period of time relative to the period of time for ramping up the charge, for simulating collapse of a dome-type switch (step 420).

Next, the end of the touch event is detected (step 430). When the measured force at the force sensors is reduced to a force below a predetermined force, the end of the touch event is detected. The predetermined force can be lower than the threshold force described above for reducing the chance of false detection of an end of a touch event and successive start of another touch event if the external applied force hovers such that the measured force hovers at about the threshold applied force. A suitable current is applied to the piezo disk actuator 90, causing an increase in charge, flexing of the piezo disk actuator 90 and a resulting force to be applied to the touch screen display 38 through the support tray 84 over a relatively short period of time compared to the period of time for ramping up the charge, for simulating release of a dome-type switch (step 440). Next, the electrical charge is reduced and the resulting force applied by the piezo disk actuator 90 on the touch screen display 38 is reduced by ramping down over a long period of time compared to the period of time for increasing charge to simulate release.

The charge and/or discharge current applied to the piezoelectric disk 92 is therefore modulated to modulate the force from the piezo disk actuators 90 on the touch screen display 38 for providing a desirable tactile feedback by simulating collapse of a dome-type switch in response to detection of the touch event and by simulating release of a dome-type switch upon detection of an end of the touch event.

The process ends at step 450.

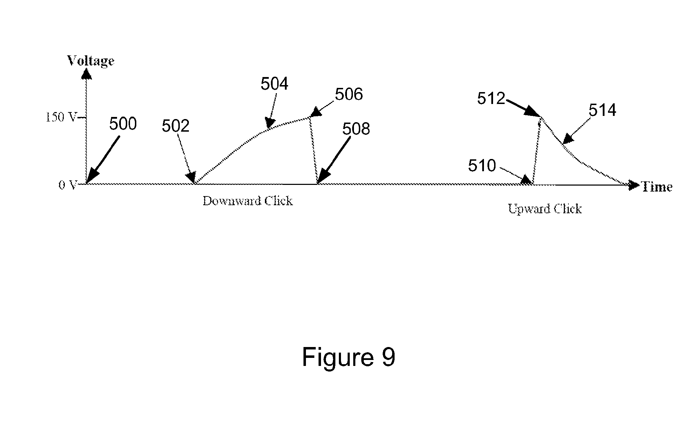

Referring now to Figure 9, there is shown a simplified example of a graph of voltage across the piezoelectric disk 92 versus time during operation of the portable electronic device 20. It will be appreciated that the voltage is the voltage across one of the piezoelectric disk 92, which is related to the charge at the piezoelectric disk 92. This example is provided to illustrate an embodiment of the present disclosure, is intended to be illustrative only and is not intended to limit the scope of the present disclosure. The portable electronic device 20 in this example is in an on or awake state and awaiting input (step 400). A user touches the screen at the point indicated by the numeral 500 and the external force applied, by the user, on the touch screen display 38 increases causing the touch screen display 38 to move towards the base 82 and resulting in deflection of the piezo disk actuators. Referring to the initial peek labeled "Downward Click" in Figure 9, the touch event is first detected at the point indicated by the numeral 502 (step 410). Prior to detection of the touch event, the measured force at the force sensors 96 is below the threshold force and therefore the piezo disk actuators 90 are not actuated. When the threshold force is reached at the point indicated by the numeral 502, the touch event is detected and the piezo disk actuators 90 are actuated by an applied current to each of the piezoelectric disks 92. The applied current is controlled to ramp up the charge over a period of time such that the force on the touch screen display 38 and any resulting deflection of the touch screen display 38 is not detected by the user. For example, the external force applied by the user touch on the touch screen display can be about 1.5N. The piezoelectric actuator 90 provides an opposing spring force and when actuated can ramp up to an additional opposing force of about 0.7N over a period of about 20 milliseconds. The portion of the curve indicated by the numeral 504 illustrates the increase in voltage across one of the piezoelectric disks 92 as a result of the applied current to charge the piezoelectric disk 92. After ramp up of the charge over the period of time, the charge on the piezoelectric disks 92 is removed by a suitable discharge current, thereby reducing the voltage across the piezo electric disks 92. The charge is removed over a much shorter period of time relative to the period of time for ramp up. For example, the additional opposing force of about 0.7N can be reduced to about 0 over a period of about 3 milliseconds between the points indicated by the numeral 506 and 508, thereby causing movement of the touch screen display 38 toward the base 82, simulating collapse of a dome-type switch and providing the user with desirable tactile feedback (step 420). The user then begins to lift the finger from the touch screen display 38, to end the touch event and the external applied force on the touch screen display 38 is therefore reduced between the points 508 and 510 in Figure 9. Referring to the peek labeled "Upward Click" in Figure 9, the end of the touch event is detected (step 430) as the measured force at the force sensors 96 falls below a predetermined level. In response to determining the end of the touch event, the applied current to the piezoelectric disks 92 is controlled to increase the charge and thereby increase the voltage across the piezoelectric disks 92 between the points indicated by the numerals 510 and 512, increasing the force applied by the piezoelectric actuator 90 on the touch screen display 38 resulting in movement of the touch screen display 38 away from the base 82 over a very short period of time as compared to the period of time for ramp up, as described above. In the example shown in Figure 9, the end of the touch event is detected at the point indicated by the numeral 510 and the piezoelectric disks 92 can be charged to increase the additional force of the piezoelectric actuator on the touch screen display 38 to about 0.7N to cause movement of the touch screen display 38 between the points indicated by the numerals 510 and 512. The current can be applied to increase the voltage across the piezoelectric disks 92 over a.period of about 3 milliseconds, as shown in the portion of the graph of Figure 9 from the numerals 510 to 512, thereby increasing the force to simulate the release of a dome-type switch and again providing the user with desirable tactile feedback (step 440). After the increase in charge, the charge on the piezo disk 92 is removed by a discharge current, thereby reducing the voltage across the piezoelectric disks 92 to reduce the additional applied force to about 0 over a much longer period of time relative to the period of time for simulating release of the dome-type switch. For example, the discharge current can be applied to reduce the voltage across the piezoelectric disks 92 over a ramp down or decay period of about 20 milliseconds, as shown in the portion of the graph of Figure 9 indicated by the numeral 514, thereby removing the applied force by the piezo actuators 90 over a period of time such that the reduction is not detected by user touch. The method ends at step 450.

The microprocessor 100 can provide a signal to the main processor 22 of the portable electronic device 20 when the measured force at the force sensors 96 as a result of the external applied force exceeds the threshold. Similarly, the microprocessor 100 can provide a signal to the main processor 22 of the portable electronic device 20 when the external applied force is reduced so that the measured force at the force sensors 96 falls below the predetermined force. Thus, the main processor 22 of the portable electronic device 20 can receive input from the actuating arrangement 39.

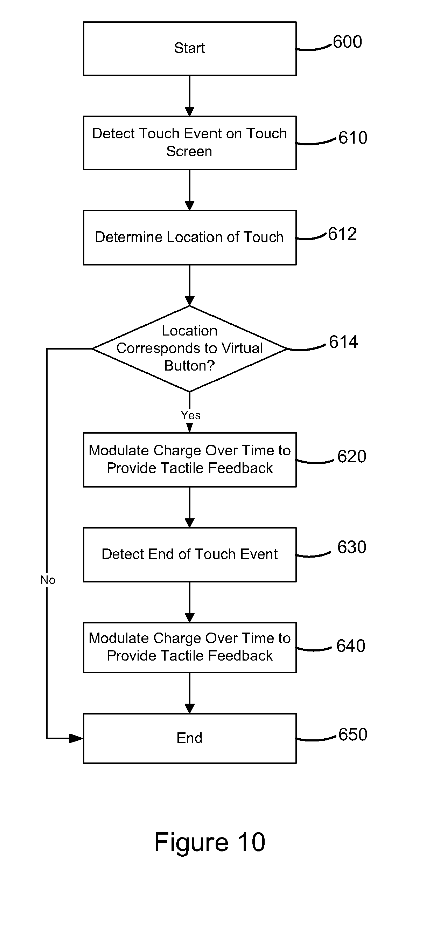

Reference is now made to Figure 10 to describe a method of controlling a portable electronic device in accordance with still another embodiment. The steps of Figure 10 can be carried out by routines or subroutines of software executed by the processor 22.

Steps 600, 610, 620, 630, 640 and 650 are similar to steps 400, 410, 420, 430, 440 and 450, respectively and are therefore not further described herein. In the present embodiment, however, the microprocessor 100 communicates with the main processor 20 such that tactile feedback is only provided at step 620 if the location of touch on the touch screen display 38 corresponds to a virtual button or other user-selectable feature on the touch screen display 38. Thus, after detection of the touch event at step 610, the X and Y location of the touch event are determined at the main processor (step 612) and it is determined if the X and Y location of the touch event correspond to a user-selectable feature (step 614). Thus, it is determined if the X and Y location of the touch corresponds to a user-selectable icon, a virtual button or key or any other suitable feature rendered on the display 32. If the X and Y location of the touch event corresponds with the location of a user-selectable feature, the process proceeds to step 620 where the charge at the piezo disk actuator 90 is modulated over time to provide tactile feedback as described above with reference to step 420 of Figure 8. Otherwise, the method ends (step 650).

It will now be appreciated that in addition to detection of a touch event by the actuating arrangement 39, the microprocessor 100 can communicate with the main processor 22 of the portable electronic device 20 for selectively providing tactile feedback only when the touch event is determined to occur at a user-selectable feature on the touch screen display 38.

The flow chart shown is simplified for the purpose of explanation. A further touch event can be detected again and the steps can be repeated, for example. The further touch event can be detected by a further increase in force and/or by detecting the touch as a result of a change in capacitance at the capacitive touch screen display 38.

The actuating arrangement 39 as described herein is not limited to piezo disk actuators 90 as described above as other piezoelectric actuators can be used. For example, a piezoelectric patch transducer 110 fixed to an elastically deformable metal substrate 112 can be used rather than piezo disk actuators. The metal substrate 112 and the piezoelectric patch transducer 110 are located between the support tray 84 of the touch screen display 38 and the base 82 for modulation of a charge at the piezoelectric patch transducer 110 to apply a bending force on the substrate 112 for applying a force to the touch screen display 38.

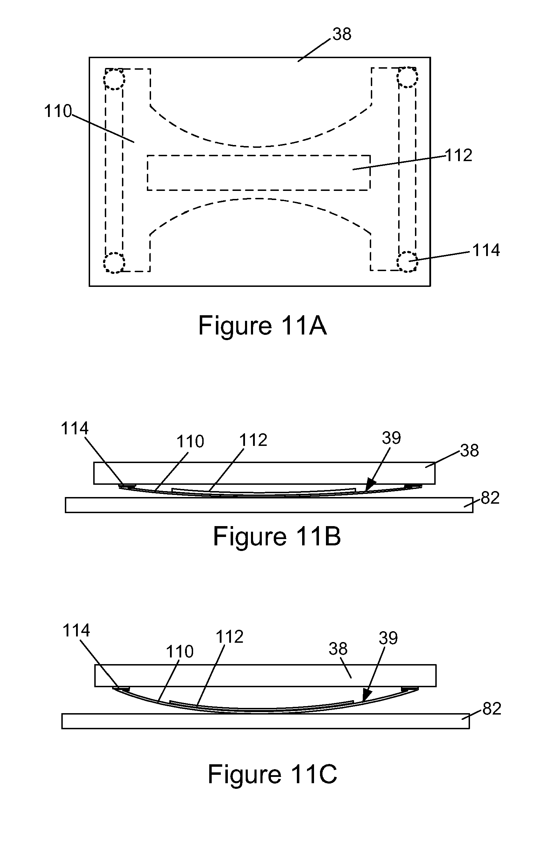

Reference is made to Figures 11A, 11B and 11C to describe an example of an actuating arrangement including a piezoelectric patch transducer 110 in accordance with another embodiment. Figure 11A is a top view of a portion of the portable electronic device 20 including a touch screen display 38 showing hidden detail including the actuating arrangement 39. Figures 11B and 11C are side views of portions of the portable electronic device 20 and, for the purpose of illustration and ease of understanding, are not drawn to scale. In the present example, the actuating arrangement 39 is supported on one side of the base 82 while the opposing side provides mechanical support and electrical connection for other components of the portable electronic device 20.

The actuating arrangement 39 includes the metal substrate 112 and the piezoelectric patch transducer 110. The metal substrate 86 can be aluminum, magnesium or any other suitable substrate capable of elastic deformation. In the present example, the metal substrate 112 includes an arcuate body with a concave side of the arcuate body facing the touch screen display 38. The arcuate body can be any suitable shape for bending. In the present example, as shown in Figure 11A, the arcuate body is generally hour-glass shaped such that the width of arcuate body is smallest at the center, closest to the base 82. The arcuate body therefore extends from the center, adjacent the base 82, toward the touch screen display 38 such that each end is adjacent the touch screen display 38. A pair of feet extend inwardly with a respective one of the pair of feet extending in from each end of the metal substrate, providing support for the touch screen display 38. Alternatively, the feet can extend outwardly. Force sensors 114 can be located between the metal substrate 112 and the base 82 for detecting an applied force during a touch event on the touch screen display 38.

The piezoelectric patch transducer 110 is a flexible transducer that is fixed to the arcuate body of the metal substrate 112 in any suitable manner, for example, using an adhesive such as an epoxy, and extends longitudinally along the arcuate body such that the piezoelectric patch transducer 110 is also arcuate-shaped. The electric charge on the piezoelectric patch transducer 110 can be modulated by modulating an applied voltage or current to the piezoelectric patch transducer 110, resulting in a contraction of the length and/or width of the piezoelectric patch transducer 110 which results in an inward flexing force of the piezoelectric patch transducer 110 on the arcuate body, to decrease the radius of curvature of the arcuate body and the piezoelectric patch transducer 110. The removal of the electric charge on the piezoelectric patch transducer 110 releases the contractual force of the piezoelectric patch transducer 110, thereby releasing the flexing force on the arcuate body caused by the piezoelectric patch transducer 110. Thus, modulation of the electric charge by controlling the applied voltage or current results in changes to forces on the touch screen display 38. Figure 11B shows a side view of portions of the touch screen display unit 80 absent the flexing force from the piezoelectric patch transducer 110. Figure 11C shows a side view of portions of the touch screen display unit 80 with the flexing force from the piezoelectric patch transducer 110 (resulting from an electrical charge on the piezoelectric patch transducer 110). Although the flexing force from the piezoelectric patch transducer 110 applies to increase the curvature of the metal substrate 112 (decreasing the radius of curvature), it will be appreciated that the flexing force may not result in the movement depicted in Figure 11C as movement of the touch screen display 38 may be constrained by, for example, the housing 74 or by a counterforce applied by a user pushing the touch screen display 38 with his or her finger. Further, Figures 11B and 11C are not to scale. These figures and the curvatures shown in the metal substrate 112 and the piezoelectric patch transducer 110 are exaggerated for the purpose of the present explanation. Movement may be small by comparison to that shown in the Figures.

It will now be appreciated that a flexing force on the arcuate body is translated through metal substrate 112 to the touch screen display 38. Flexing movement of the piezoelectric patch transducer 110 and the metal substrate 112 is translated to the touch screen display 38 as a force is applied to move the touch screen display 38 away from the base 82 as a result of the force applied by the piezoelectric patch transducer 110 on the metal substrate 112. The force is then reduced or removed when the electrical charge of the piezoelectric patch transducer 110 is removed. It will be appreciated that the substrate material and thickness can be chosen based on stiffness, a stiffer substrate, permitting less deflection.

The portable electronic device 20 can be controlled by controlling the movement of the touch screen display 38 using the piezoelectric patch transducer 110. Referring again to Figure 8, for example, during operation of the device (step 400), a touch event on the touch screen display 38 can be determined (step 410), the piezoelectric patch transducer 110 can be controlled by modulating the applied current to ramp up the charge on the piezoelectric patch transducer 110 and thereby increase the force from the piezoelectric patch transducer 110 on the touch screen display 38 over a period of time such that the force and any resulting movement of the touch screen display 38 is not significantly detectable by the user touching the touch screen display 38. The charge on the piezoelectric patch transducer 110 can be removed via a controlled discharge current over a very short period of time relative to the period of time for ramp-up to simulate the actuation of a dome-type switch, thereby providing tactile feedback to the user of the device (step 420). When the end of the touch event is detected (step 430) the piezoelectric patch transducer 110 can be controlled by modulating the applied current to increase the charge on the piezoelectric patch transducer 110 and thereby increase the force from the piezoelectric patch transducer 110 on the touch screen display 38 over a very short period of time relative to the period of time for ramp-up at step 420, thereby simulating release of a dome-type switch and providing further tactile feedback to the user (step 440). The charge on the piezoelectric patch transducer 110 can then be removed via a controlled discharge current over a long period of time relative to the period of time for ramping down. The process ends at step 450.

In embodiments, the actuating arrangement can be used for providing tactile feedback as described as well as for providing a vibration, for example, for a notification of receipt of an email, cellular phone call, for a reminder or any other suitable notification. Such vibration notifications can be provides using the same actuating arrangement and by controlling the charge and discharge of capacitance at the actuating arrangement. Thus, a further device such as, for example, a vibratory motor is not needed for vibration of the device.

In other examples of embodiments, the actuating arrangement can differ substantially. In particular, the shape of the metal substrate 112 can differ from that shown and described. Furthermore, an additional piezoelectric patch transducer or transducers can be employed on the metal substrate 112 or on separate metal substrates.

In the above-described embodiments, the actuating arrangement is employed between a touch screen display and a base of the portable electronic device. In other embodiments, the actuating arrangement can be employed with a substrate in a bending configuration between any base and any suitable input such as a touch-sensitive input control pad or other touch-sensitive input surface.

In still other embodiments, an electrostrictive material may be used rather than a piezoelectric material. A magnetostrictive material may also be employed. Similarly, an electroactive polymer may be used rather than a piezo actuator.

The actuating arrangement provides a relatively thin device for providing a desirable tactile feedback to the user without adding significantly to the thickness of the device. Further, the actuating arrangement can be controlled to provide tactile feedback upon detection of a touch event such that tactile feedback that simulates actuation of a dome-type switch is provided for each touch event. Thus, this tactile feedback can be provided each time a finger touches the touch screen display or each time a force exceeds a threshold force. Further a single simulation of a dome-type switch can be provided for a single touch event.

Further still, the tactile feedback may be controlled to provide different tactile feedback for touch events at different areas on the touch screen display. Thus, feedback may be controlled such that touching the touch screen display at an area that does not correspond to a virtual button or feature, for example, does not result in provision of tactile feedback while touching the touch screen display at an area that corresponds to a virtual button or feature results in provision of such tactile feedback. The tactile feedback can be selectively provided based on applied force by the user when touching the touch screen display. Thus, tactile feedback is provided when the applied force meets or exceeds a threshold.

While the embodiments described herein are directed to particular implementations of the portable electronic device and the method of controlling the portable electronic device, it will be understood that modifications and variations may occur to those skilled in the art. All such modifications and variations are believed to be within the sphere and scope of the present disclosure.

## Claims

1.  A method of controlling an electronic device having a touch-sensitive input surface, the method comprising:

    monitoring the touch-sensitive input surface for a touch event thereon; and
    modulating a force on the touch-sensitive input surface for causing a first movement of the touch-sensitive input surface relative to a base of the electronic device in response to detection of a touch event on the touch-sensitive input surface, wherein the force is applied by at least one actuator in a single direction on the touch-sensitive input surface.

2.  The method according to claim 1, wherein modulating the force on the touch-sensitive input surface for causing the first movement comprises reducing the force over a collapse time period for causing the touch-sensitive input surface to move toward the base for simulating collapse of a dome-type switch.

3.  The method according to claim 2, wherein modulating the force on the touch-sensitive input surface for causing the first movement comprises increasing the force on the touch-sensitive input surface, in a direction away from the base, over a ramp-up time period prior to said reducing the force over a collapse time period.

4.  The method according to claim 3, wherein the ramp-up time period of time is longer than the collapse time period.

5.  The method according to any preceding claim, comprising modulating the force on the touch-sensitive input surface for causing a second movement of the touch-sensitive input surface relative to the base in response to detecting an end of the touch event on the touch-sensitive input surface.

6.  The method of claim 5, wherein modulating the force on the touch-sensitive input surface for causing the second movement comprises increasing the force over a release time period for causing the touch-sensitive input surface to move away from the base for simulating release of the dome-type switch.

7.  The method according to claim 6, wherein modulating the force on the touch-sensitive input surface for causing the second movement comprises decreasing the force on the touch-sensitive input surface over a ramp-down time period after said increasing the force over the release time period.

8.  The method according to claim 7, wherein said ramp-down time period is longer than the release time period.

9.  The method according to any preceding claim, wherein modulating the force on the touch-sensitive input surface for causing the first movement comprises modulating the charge at at least one piezoelectric actuator disposed between the base and the touch-sensitive input surface for controlling the force on the touch-sensitive input surface.

10. The method according to claim 9, wherein modulating the charge at at least one piezoelectric actuator comprises modulating a respective charge at each of a plurality of piezoelectric actuators, each piezoelectric actuator comprising a piezoelectric disk adhered to an elastically deformable substrate for deforming to modulate the force on the touch sensitive input surface.

11. The method according to claim 9, wherein modulating the charge at at least one piezoelectric actuator comprises modulating a respective charge at at least one piezoelectric patch transducer adhered to an elastically deformable substrate for deforming to modulate the force on the touch-sensitive input surface.

12. The method according to any preceding claim, wherein monitoring comprises monitoring an external applied force on the touch-sensitive input surface and wherein modulating the force on the touch-sensitive input surface for causing a first movement comprises modulating the force applied by at least one actuator in response to determining that the external applied force on the touch-sensitive input surface exceeds a threshold force.

13. The method according to claim 12, wherein monitoring a force comprises monitoring the external applied force at at least one force-sensing resistor disposed between the touch-sensitive input surface and said base.

14. The method according to claim 12 or claim 13, comprising modulating the force on the touch-sensitive input surface for causing a second movement of the touch-sensitive input surface relative to the base of the electronic device in response to determining that the external applied force exceeds a second threshold force.

15. The method according to any preceding claim, wherein the touch-sensitive input surface is disposed on an LCD display for providing a touch screen display and wherein said method comprises rendering a graphical user interface including at least one user-selectable feature on the touch screen display.

**16.** The method according to claim 15, wherein modulating the force on the touch-sensitive input surface comprises modulating the force in response to detection of the touch event if said touch event is determined to occur at said at least one user-selectable feature.

**17.** The method according to claim 1, wherein modulating the force on the touch-sensitive input surface for causing the first movement comprises increasing the force for causing the touch-sensitive input surface to move away from the base.

**18.** An electronic device comprising:

a base;
a touch-sensitive input surface spaced from and moveable relative to the base; and
an actuating arrangement comprising at least one actuator between the base and the touch-sensitive input surface for modulation of a force on the touch-sensitive input surface for causing a first movement of the touch-sensitive input surface relative to a base of the electronic device in response to detection of a touch event on the touch-sensitive input surface, wherein the force is applied by the at least one actuator in a single direction on the touch-sensitive input surface.

**19.** The electronic device according to claim 18, comprising at least one force sensor disposed between the base and the touch-sensitive input surface for detecting an externally applied force on the touch-sensitive input surface.

**20.** The electronic device according to claim 18 or claim 19, comprising a display on which the touch-sensitive input surface is disposed for providing a touch screen display.

**21.** A computer-readable medium having computer-readable code embodied therein for execution by a processor in an electronic device having a touch-sensitive input surface, for carrying out the steps of the method according to any one of claims 1 to 17.

**Amended claims in accordance with Rule 137(2) EPC.**

**1.** A method of controlling an electronic device (20) having a touch-sensitive display (38) and a base (82), the method comprising:

detecting a touch event on the touch-sensitive display (38); and
in response to detecting the touch event on the touch-sensitive display (38), imparting, by at least one actuator (90), a force on the touch-sensitive display (38), in a direction away from the base (82), by increasing the force over a ramp-up time period and reducing the force over a collapse-time period.

**2.** The method according to claim 1, wherein the ramp-up time period is longer than the collapse time period.

**3.** The method according to any preceding claim, comprising in response to detecting an end of the touch event on the touch-sensitive display (38), imparting, by the at least one actuator (90), a force on the touch-sensitive display (38), in a direction away from the base (82), by increasing the force over a release time period.

**4.** The method according to claim 3, comprising reducing the force over a ramp-down time period after increasing the force over the release time period.

**5.** The method according to claim 4, wherein the ramp-down time period is longer than the release time period.

**6.** The method according to any preceding claim, wherein imparting, by at least one actuator (90), a force on the touch-sensitive display (38) comprises modulating a charge at at least one piezoelectric actuator (90) disposed between the base (82) and the touch-sensitive display (38) to control the force imparted on the touch-sensitive display (38).

**7.** The method according to claim 6, wherein modulating the charge at the at least one piezoelectric actuator (90) comprises modulating a respective charge at each of a plurality of piezoelectric actuators (90), each piezoelectric actuator (90) comprising a piezoelectric disk (92) adhered to an elastically deformable substrate, the piezoelectric disk configured to deform to impart the force on the touch-sensitive display (38).

**8.** The method according to claim 6, wherein modulating the charge at at least one piezoelectric actuator (90) comprises modulating a respective charge at at least one piezoelectric patch transducer (110) adhered to an elastically deformable substrate, the at least one patch transducer configured to deform to impart the force on the touch-sensitive display (38).

**9.** The method according to any preceding claim, wherein detecting comprises detecting an external applied force on the touch-sensitive display (38) and in response to determining that the detected external applied force on the touch-sensitive display (38) exceeds a threshold force, imparting, by at least one actuator (90), a force on the touch-sensitive display (38), in a direction away from the base (82), by increasing the force over a ramp-up time period and reducing the force over a collapse-time period, wherein the ramp-up time period is longer than the collapse-time period.

**10.** The method according to claim 7, wherein detecting the external applied force on the touch-sensitive display (38) comprises detecting the external applied force at at least one force-sensing resistor disposed between the touch-sensitive display (38) and the base (82).

**11.** The method according to claim 9 or claim 10, comprising, in response to determining that the detected external applied force exceeds a second threshold force, imparting, by at least one actuator (90), a force on the touch screen display (38), in a direction away from the base (82), by increasing the force over a release time period.

**12.** The method according to any preceding claim, wherein the touch-sensitive display (38) comprises a touch-sensitive overlay (34) disposed on an LCD display (32) and wherein the method comprises rendering a graphical user interface including at least one user-selectable feature on the LCD display (32).

**13.** The method according to claim 12, comprising, in response to detecting a touch event on the touch-sensitive display (38), determining if the touch event occurred at the at least one user-selectable feature, and in response to determining that the detected touch event occurred at the at least one user-selectable feature, imparting, by at least one actuator (90), a force on the touch-sensitive display (38), in a direction away from the base (82), by increasing the force over a ramp-up time period and reducing the force over a collapse-time period, wherein the ramp-up time period is longer than the collapse-time period.

**14.** An electronic device (20) comprising:

a base (82);
a touch-sensitive display (38) spaced from and moveable relative to the base (82); and
an actuating arrangement (39) comprising at least one actuator between the base (82) and the touch-sensitive display (38), and
a memory (28, 30);
a processor (22) operatively coupled to the memory (28, 30) and the actuating arrangement (39), the processor (22) being configured to execute computer-readable code stored in the memory (28, 30) to carry out the steps of the method according to any one of claims 1 to 13..

**15.** The electronic device (20) according to claim 14, comprising at least one force sensor (96) disposed between the base (82) and the touch-sensitive display (38), the at least one force sensor being configured to detect an externally applied force on the touch-sensitive display (38).

**16.** The electronic device according to claim 14 or claim 15, wherein the touch-sensitive display (38) comprises a touch-sensitive overlay (34) disposed on a LCD display (32).

**17.** A computer-readable medium having computer-readable code embodied therein executable by a processor (22) in an electronic device (20) having a touch-sensitive display (38), to carry out the steps of the method according to any one of claims 1 to 13.

Figure 1

20

74

38

Menu

Figure 2

Figure 3A

Figure 3B

Figure 3C

Figure 4

Figure 5

```
┌─────────────────────────────┐
│            Start            │ ⌐ 200
└─────────────────────────────┘
               │
               ▼
┌─────────────────────────────┐
│  Detect Touch Event on Touch │ ⌐ 210
│           Screen            │
└─────────────────────────────┘
               │
               ▼
┌─────────────────────────────┐
│  Modulate Charge Over Time to│ ⌐ 220
│   Provide Tactile Feedback   │
└─────────────────────────────┘
               │
               ▼
┌─────────────────────────────┐
│             End             │ ⌐ 250
└─────────────────────────────┘
```

# Figure 6

Figure 7

```
┌─────────────────────────┐
│          Start          │ ───── 400
└─────────────────────────┘
             │
             ▼
┌─────────────────────────┐
│ Detect Touch Event on Touch │ ───── 410
│          Screen          │
└─────────────────────────┘
             │
             ▼
┌─────────────────────────┐
│ Modulate Charge Over Time to │ ───── 420
│ Provide Tactile Feedback │
└─────────────────────────┘
             │
             ▼
┌─────────────────────────┐
│   Detect End of Touch Event  │ ───── 430
└─────────────────────────┘
             │
             ▼
┌─────────────────────────┐
│ Modulate Charge Over Time to │ ───── 440
│ Provide Tactile Feedback │
└─────────────────────────┘
             │
             ▼
┌─────────────────────────┐
│           End           │ ───── 450
└─────────────────────────┘
```

Figure 8

Figure 9

```
          ┌─────────────────────┐
          │        Start        │────600
          └─────────────────────┘
                     │
                     ▼
          ┌─────────────────────┐
          │ Detect Touch Event  │────610
          │   on Touch Screen   │
          └─────────────────────┘
                     │
                     ▼
          ┌─────────────────────┐
          │ Determine Location  │────612
          │      of Touch       │
          └─────────────────────┘
                     │
                     ▼
               ◇─────────────◇
              ╱   Location    ╲
    ┌───────◇ Corresponds to  ◇────614
    │        ╲ Virtual Button?╱
    │          ◇─────────────◇
    │                │
    │               Yes
    │                ▼
    │     ┌─────────────────────┐
    │     │ Modulate Charge Over│────620
    │     │  Time to Provide    │
    │     │  Tactile Feedback   │
    │     └─────────────────────┘
    │                │
    │                ▼
    │     ┌─────────────────────┐
    │     │ Detect End of Touch │────630
    │     │       Event         │
    │     └─────────────────────┘
   No                │
    │                ▼
    │     ┌─────────────────────┐
    │     │ Modulate Charge Over│────640
    │     │  Time to Provide    │
    │     │  Tactile Feedback   │
    │     └─────────────────────┘
    │                │
    │                ▼
    │     ┌─────────────────────┐
    └────▶│        End          │────650
          └─────────────────────┘
```

Figure 10

27

Figure 11A

Figure 11B

Figure 11C

Europäisches
Patentamt
European
Patent Office
Office européen
des brevets

# EUROPEAN SEARCH REPORT

**Application Number**

EP 08 17 2725

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/068348 A1 (ROSENBERG LOUIS B [US] ET AL) 20 March 2008 (2008-03-20) * the whole document * | 1-21 | INV. G06F3/041 G06F3/01 |
| X | US 2006/119586 A1 (GRANT DANNY A [CA] ET AL) 8 June 2006 (2006-06-08) * the whole document * | 1-21 | |
| A | CA 2 518 914 A1 (HANDSHAKE VR INC [CA]) 23 September 2004 (2004-09-23) * pages 3-9 * * figures 1-5 * | | |
| A | US 2006/209037 A1 (WANG DAVID [CA] ET AL) 21 September 2006 (2006-09-21) * the whole document * | | |
| A | EP 1 748 350 A (AVAGO TECHNOLOGIES GENERAL IP [SG]) 31 January 2007 (2007-01-31) * the whole document * | | |
| A | EP 2 000 885 A (RES IN MOTION LTD [CA]) 10 December 2008 (2008-12-10) * the whole document * | | TECHNICAL FIELDS SEARCHED (IPC) G06F |

The present search report has been drawn up for all claims

| Place of search | Date of completion of the search | Examiner |
|---|---|---|
| The Hague | 12 May 2009 | Meyer, André |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 17 2725

This annex lists the patent family members relating to the patent documents cited in the above-mentioned European search report.
The members are as contained in the European Patent Office EDP file on
The European Patent Office is in no way liable for these particulars which are merely given for the purpose of information.

12-05-2009

| Patent document cited in search report | | Publication date | Patent family member(s) | | Publication date |
|---|---|---|---|---|---|
| US 2008068348 | A1 | 20-03-2008 | US | 2008068349 A1 | 20-03-2008 |
| | | | US | 2008068350 A1 | 20-03-2008 |
| | | | US | 2008068351 A1 | 20-03-2008 |
| US 2006119586 | A1 | 08-06-2006 | NONE | | |
| CA 2518914 | A1 | 23-09-2004 | NONE | | |
| US 2006209037 | A1 | 21-09-2006 | NONE | | |
| EP 1748350 | A | 31-01-2007 | US | 2007024593 A1 | 01-02-2007 |
| EP 2000885 | A | 10-12-2008 | CA | 2634098 A1 | 08-12-2008 |

For more details about this annex : see Official Journal of the European Patent Office, No. 12/82

EPO FORM P0459